# EUROPEAN PATENT SPECIFICATION

(11) **EP 0 567 104 B1**
(45) Date of publication and mention of the grant of the patent: **01.07.1998**
(21) Application number: 93106502.3
(22) Date of filing: 21.04.1993
(51) Int. Cl.: G11C 29/00, G11C 11/406

(54) **Semiconductor memory device having a self-refresh function**
Halbleiterspeichervorrichtung mit Selbstauffrischungsfunktion
Dispositif de mémoire à semi-conducteurs possédant un rafraîchissement propre

(30) Priority: 22.04.1992 KR 672892
(43) Date of publication of application: 27.10.1993
(73) Proprietor: SAMSUNG ELECTRONICS CO., LTD., Suwon-city, Kyungki-do 441-373 (KR)
(72) Inventor: Kang, Kyung-Woo, Suwon-city, Kyungki-do (KR)
(74) Representative: Grünecker, Kinkeldey, Stockmair & Schwanhäusser Anwaltssozietät

(56) References cited:
- US-A- 4 672 583
- US-A- 4 933 908

## Description

The present invention relates to a semiconductor memory device according to the preamble part of claim 1 which has a self-refresh function with using an internal self-refresh address.

As a semiconductor memory device having a self-refresh function, a dynamic random access memory (referred to as DRAM hereinafter) has been known. The DRAM comprises a memory cell array consisted of a plurality of memory cells which are coupled with a plurality of word lines and a plurality of bit lines arranged in matrix, and peripheral circuits for controlling read and write operation of data into and from the memory cell selected by a combination of the word line and bit line. Each of the memory cells in the DRAM comprises a single MOSFET (metal-oxide-semiconductor field effect transistor) and a single capacitor. Data written into a memory cell is charged in the single capacitor of the memory cell, and the logic state of the data is determined by the amount of the charge stored in the single capacitor. For protecting the data stored in the single capacitor of a memory cell from degradation thereof due to a current leakage with lapse of time, a refresh function is provided to the memory cell in order to restore an original data level of the memory cell. In recent DRAMs, the refresh operation is automatically performed with a predetermined period, repeatedly, and made by itself to all the memory cells embedded in the DRAM. Such is called as a self-refresh operation wherein addresses for selecting memory cells in sequence are generated in the DRAM without using external addresses as is in normal operation.

One of conventional self-refresh technologies in a DRAM has been disclosed in Japanese Patent Publication No. 61 57079 (issued on 1986), as the title of "a dynamic semiconductor memory device". In the Japanese paper, a self-refresh operation mode is enabled after a predetermined lapse time from when CAS-before-RAS refresh mode (referred to as "CBR mode" hereinafter) is initiated. If a row address strobe signal $\overline{\text{RAS}}$ is made active as "low" level while a column address strobe signal $\overline{\text{CAS}}$ is being active as "low" level, the CBR mode initiates. After the initiation of the CBR mode, if the row address strobe signal $\overline{\text{RAS}}$ still retains its activation level of "low" even until a predetermined time, for example, 16 micro-seconds, has been lapsed, then a self-refresh operation is started.

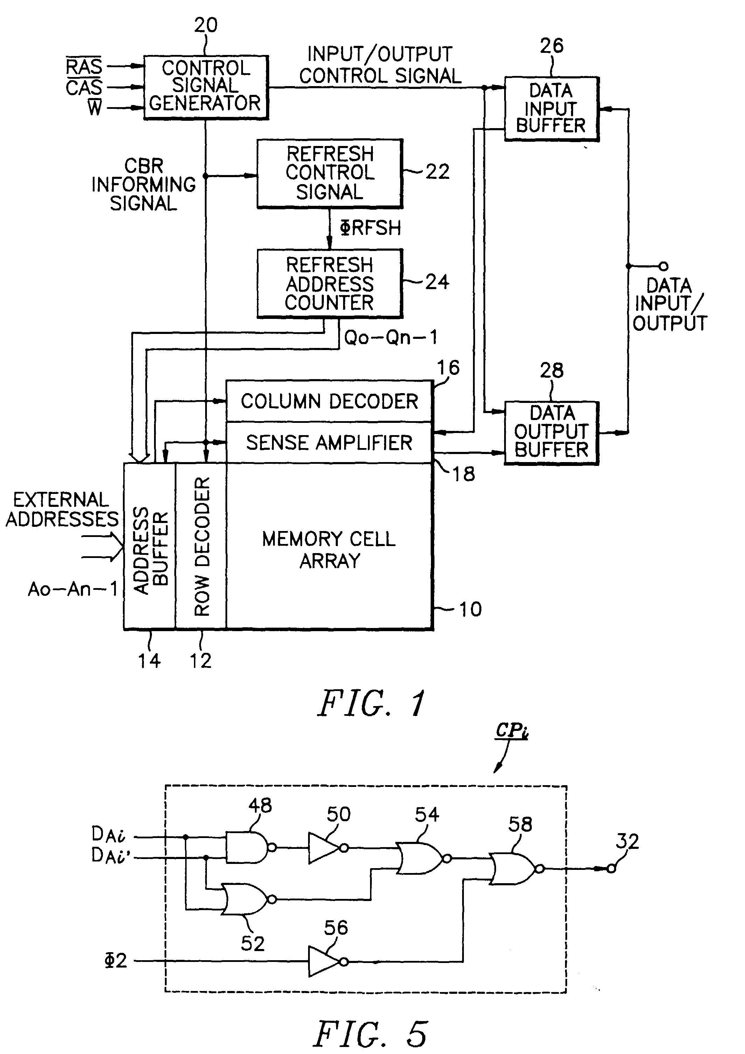

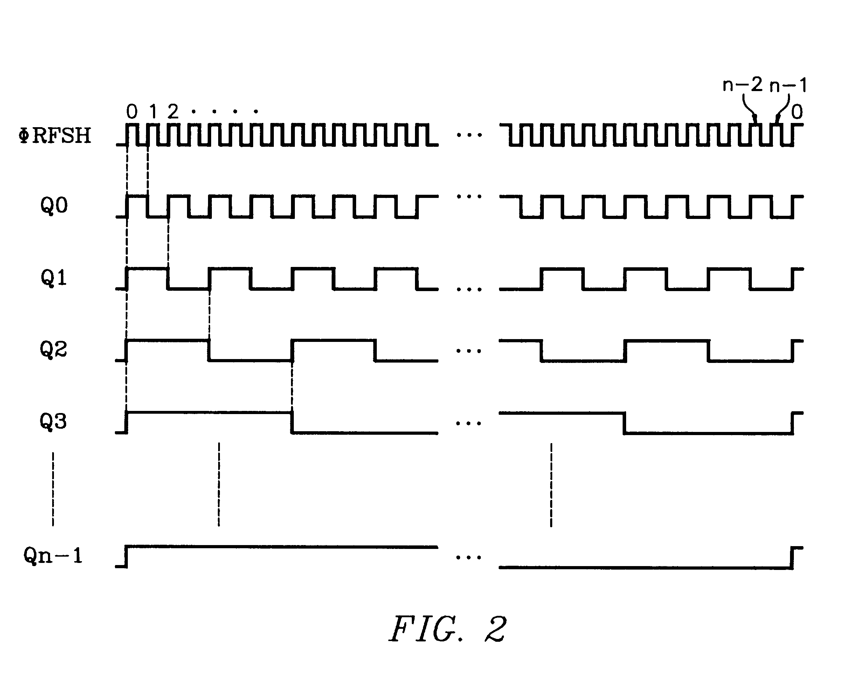

Referring to Fig.1 showing functional constitution of a DRAM employing the conventional self-refresh scheme and Fig.2 illustrating the operation timing of Fig.1, for performing a self-refresh operation, the conventional DRAM comprises a refresh control circuit 22 generating a refresh clock ΦRFSH according to a CBR informing signal made by a control signal generator 20 which receives a row address strobe signal $\overline{\text{RAS}}$ , a column address strobe signal $\overline{\text{CAS}}$ and a write signal $\overline{\text{WE}}$ , a refresh address counter 24 generating a plurality of internal refresh address signals Q₀-Qₙ₋₁ in response to the refresh clock ΦRFSH. Referring to Fig.2 which illustrates the refresh clock ΦRFSH and the internal refresh address signals Q₀-Qₙ₋₁, the refresh clock ΦRFSH is generated from the refresh control circuit 22 by an oscillator (not shown) therein, responding to initiation of the CBR informing signal. Once the refresh clock ΦRFSH is applied to the refresh address counter 24, a plurality of internal refresh address signals Q₀-Qₙ₋₁ are generated from the refresh address counter 24 and applied to a row decoder 12 and a column decoder 16, for the purpose of being used for selecting memory cells in a memory cell array 10 in regular sequence. With using the internal refresh address signals Q₀-Qₙ₋₁ a self-refresh operation is made up to the memory cells in the memory cell array 10.

However, it is impossible for the conventional self-refresh circuit as shown in Fig.1 to detect a condition about whether all the internal refresh address signals necessary to accomplishing the self-refresh operation have been completely generated, thereby, as well as to verify its cycle time as a substantial value. Since, if a semiconductor memory device products has the self-refresh function, an accurate self-refresh cycle time should be joined with its own standardization, absence of the self-refresh cycle time detecting or verifying means detracts such a memory products from reliability of itself.

From the textbook "Halbleiter-Schaltungstechnik" by U. Tietze and Ch. Schenk, Springer-Verlag 1974, pages 543 to 544, a circuit is known comprising a plurality of paths and comparators, wherein each comparator receives a first and second path, and a logical gate for receiving the output signals generated from the comparators.

The object of the present invention is to provide a semiconductor memory device in which an information about whether internal refresh address signals for one self-refresh cycle are completely generated can be detected.

This object is solved by a semiconductor memory device having the features of claim 1. Preferred embodiments are subject to various dependent claims.

The present invention will become more apparent from the following detailed description of the present invention when taken in conjunction with the accompanying drawings.

Fig. 1 is a functional block diagram of a conventional semiconductor memory device employing a self-refresh function.

Fig. 2 is a timing chart diagram of Fig. 1, showing a refresh clock and internal refresh address signals.

Fig. 3 is a functional block diagram of a semiconductor memory device comprising a refresh address test circuit according to the present invention.

Fig. 4 shows an embodiment of the refresh address test circuit of Fig,3, according to the present invention.

Fig. 5 shows an embodiment of a comparator provided to the refresh address test circuit of Fig.4, according to the present invention.

Fig. 6 is a timing chart diagram of Fig.3, when the semiconductor memory device according to the present invention is performing a self-refresh operation with the refresh address test circuit of Fig.4.

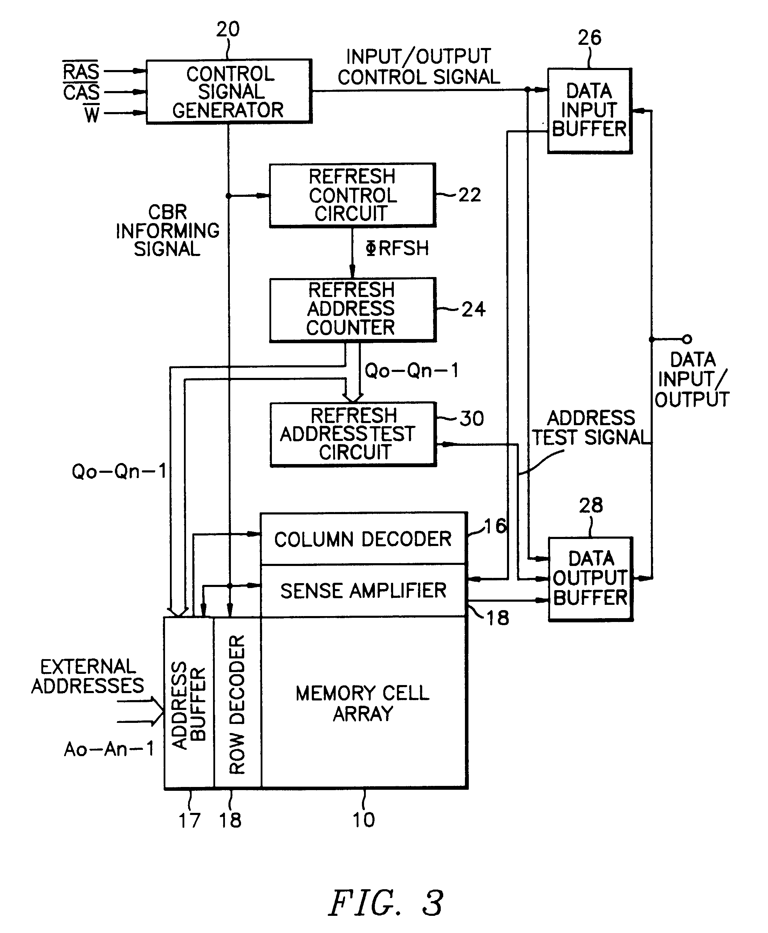

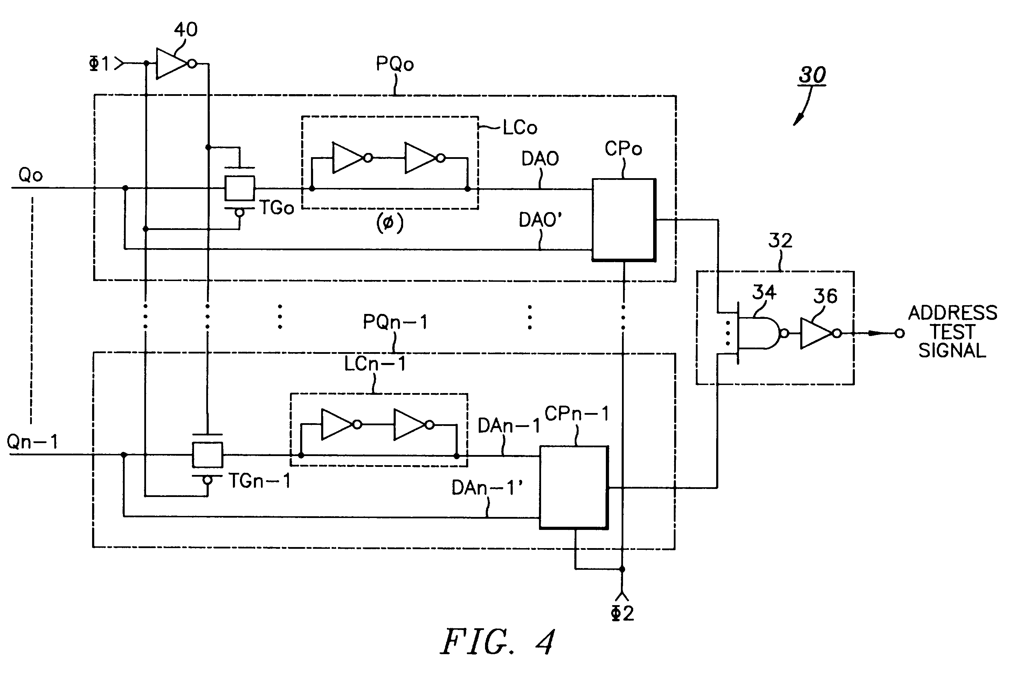

Prior to description about an embodiment according to the present invention hereinafter, note that functional block elements of Fig.3 as same as those of Fig.1 are marked with numerals as is in Fig.1. Now, referring to Fig.3, other components in Fig.3 is as same as those of Fig.1 but a refresh address test circuit 30 which receives a plurality of internal refresh address signals Q₀-Qₙ₋₁ generated from a refresh address counter 24 and applies an address test signal to a data output buffer 28. A CBR informing signal made from a control signal generator 20 from which an input/output control signal is also generated is applied to a refresh control circuit 22, an address buffer 14, a row decoder 12 and a sense amplifier 18. The address buffer 14 turns its input to the internal refresh address from the external address A₀-Aₙ₋₁ when the semiconductor memory device of Fig.3 is in a self-refresh operation mode. The data output buffer 28 makes the address test signal be generated out of the semiconductor memory device. Detail circuit of the refresh address test circuit 30 is shown in Fig.4.

Referring to Fig.4, the refresh address test circuit 30 according to the present invention comprises a plurality of address test paths PQ₀-PQₙ₋₁ receiving the plurality of the internal refresh address signals Q₀-Qₙ₋₁ applied from the refresh address counter 24, a test output circuit 32 receiving all signals passed through the address test paths PQ₀-PQₙ₋₁ and generating the address test signal which detects whether all the refresh addresses Q₀-Qₙ₋₁ for one self-refresh cycle have been completely generated.

All the plurality of the address test paths PQ₀-PQₙ₋₁ are constructed with same manner. A first address test path PQ₀ is consisted of a first sub-path DA₀, a second sub-path DA₀', a first comparator CP₀ receiving signals on the first and second sub-paths DA₀ and DA₀' and being controlled by a comparing control signal Φ2. The first sub-path DA₀ receives a first refresh address signal Q₀ and is coupled to one input terminal of the first comparator CP₀, including a first transmission gate TG₀ transferring the first refresh address signal Q₀ by means of a transmission control clock Φ1, a first latch circuit LC₀ coupled between the first transmission gate TG₀ and the one input terminal of the first comparator CP₀. The second sub-path DA₀' directly applies the first refresh address signal Q₀ to the other input terminal of the first comparator CP₀. Also in other address test paths such as second address test path PQ₁ through n'th address test path PQₙ₋₁, each of them is constructed as is in the first address test path PQ₀. For example in a case of anyone address test path PQi, the address test path PQi is consisted of a first sub-path DAi, a second sub-path DAi', an i'th comparator CPi receiving signals on the first and second sub-paths DAi and DAi' and being controlled by the comparing control clock Φ2; the first sub-path DAi receives an i'th refresh address signal Qᵢ and is coupled to one input terminal of the i'th comparator CPi, including an i'th transmission gate TGi transferring the i'th refresh address signal Qi by means of the transmission control clock Φ1 and an i'th latch circuit LCi coupled between the i'th transmission gate TGi and the one input terminal of the i'th comparator CPi; the second sub-path DAi' directly applies the i'th refresh address Qi to the other input terminal of the i'th comparator CPi.

The test output circuit 32 is made of a NAND gate 34 receiving all output signals generated from the plurality of the comparators CP₀, CP₁,..., CPₙ₋₁ and an inverter 36 coupled to an output terminal of the NAND gate 34 to convert the output signal of the NAND gate 36 to the address test signal.

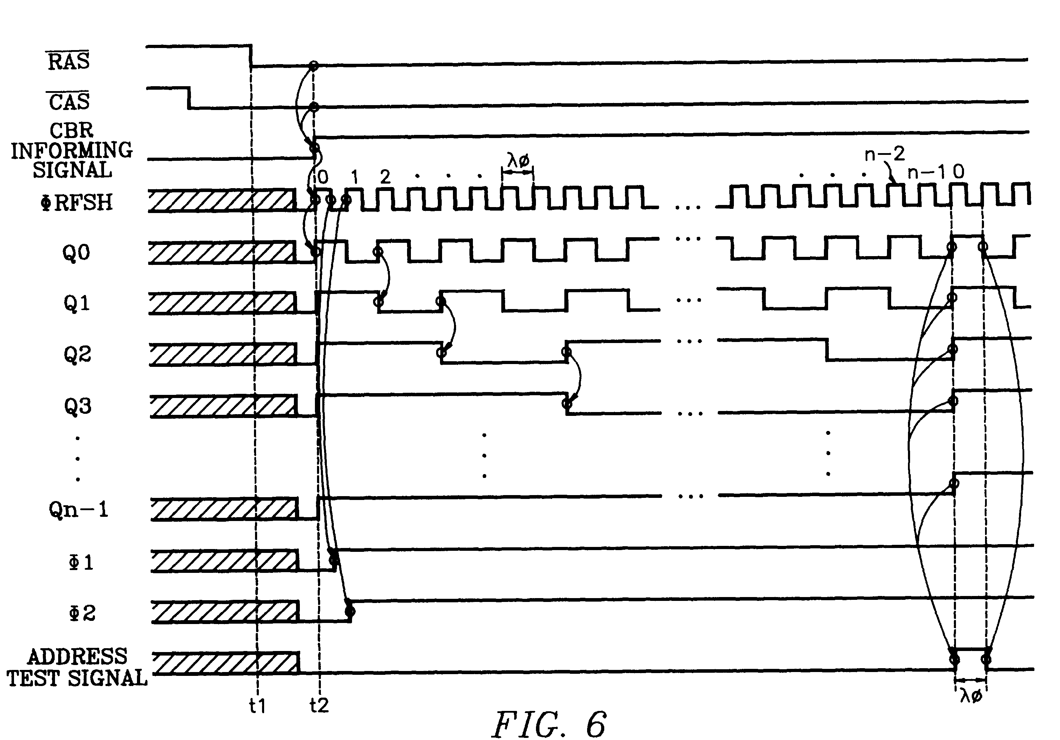

A logic circuit of the comparator employed in the address test path, as an embodiment according to the present invention, is disclosed in Fig.5. Referring to Fig.5, the i'th comparator CPi (any one of the first comparator CP₀ through the n'th comparator CPₙ₋₁ is consisted of a NAND gate 48 and a first NOR gate 52 those input terminals are commonly coupled to the first and second sub-paths DAi and DAi', an inverter 50 inverting an output signal of the NAND gate 48, a second NOR gate 54 receiving output signals from the inverter 50 and the first NOR gate 52, an inverter 56 inverting the comparing control clock Φ2, and a third NOR gate 58 receiving the output signals from the second NOR gate 54 and the inverter 56 to apply a compared output signal to the test output circuit 32.

The operation of the refresh address test circuit according to the present invention will now be described in detail with reference to Figs. 3 through 5, and Fig.6 which illustrates figures of the row address strobe signal $\overline{\text{RAS}}$ *,* a column address strobe signal $\overline{\text{CAS}}$ , the CBR informing signal, the refresh clock ΦRFSH, the control clocks Φ1 and Φ2, and the plurality of the internal refresh address signals Q₀-Qₙ₋₁. Note that though the description hereinafter for the refresh address testing operation is prosecuting just with the first address test path PQ₀ it is adaptable to the other address test paths with identical sequence. In the state of that the column address strobe signal $\overline{\text{CAS}}$ is being in its active cycle as "low" level, if a predetermined time has been lapsed after the row address strobe signal $\overline{\text{RAS}}$ turns to its active cycle as "low" level at a time t1, the CBR informing signal is generated from the control signal generator 20 of Fig.3 at a time t2 to enable a self-refresh operation mode. Then, the refresh control circuit 22 controlled by the CBR informing signal generates the refresh clock ΦRFSH, as shown in Fig.6, by means of an oscillator (not shown), and thereby the refresh address counter 24 generates the plurality of the refresh address signals Q₀-Qₙ₋₁.

During the transmission control, clock Φ1 retains "low"level, the internal refresh address signals Q₀-Qₙ₋₁ are stored into the latch circuits LC₀-LCₙ₋₁ on the first sub-paths DA₀-DAₙ₋₁, by passing through the transmission gates TG₀-TGₙ₋₁. When a first pulse of the refresh clock ΦRFSH changes from "high" level to "low" level in first self-refresh cycle, the transmission control clock Φ1 becomes "high" level. Thereby, the transmission gates TG₀-TGₙ₋₁ are closed to be disable so that the stored the initial level of the refresh address signals Q₀-Qₙ₋₁ are held on the first sub-paths DA₀-DAₙ₋₁ by the latch circuits LC₀-LCₙ₋₁ until the self-refresh operation mode has been expired, completely. Subsequently when a second pulse of the refresh clock ΦRFSH goes to "high" level, the comparing control clock Φ2 becomes "high" level to activate the comparators CP₀-CPₙ₋₁ which have two input terminals, respectively, the one connected to the output of the latch circuit storing the initial level of the refresh address signal and the other directly receiving the subsequently toggling level of the refresh address signal.

Referring to Fig.5, in the comparators CPi (any one of the CP₀₋CPₙ₋₁), the one input terminals of the NAND gate 48 and the first NOR gate 52 are coupled to the initial logic level of the refresh address signal on the first sub-path DAi (any one of the DA₀-DAₙ₋₁), and the other input terminals of the NAND gate 48 and the first NOR gate 52 are coupled to the subsequently toggling logic level of the refresh address signal on the second sub-path DAi' (any one of the DA₀'-DAₙ₋₁'). If the subsequently toggling logic level of the refresh address signal Qi (any one of the Q₀-Qₙ₋₁) is on "low" level at present, assuming that the initial level of the refresh address signal Qi (any one of the Q₀-Qₙ₋₁) has been stored in the latch circuit LCi (any one of the LC₀-LCn-1) as "high" level, the second NOR gate 54 receives an output signal of "low" level from the inverter 50 which inverts the output level of the NAND gate 48 and also receives an output signal of "low" level from the first NOR gate 52. Since the comparing control clock Φ2 retains "high" level at present in order to activate this comparator CPi (any one of the CP₀-CPₙ₋₁), the third NOR gate 58 can generate an output signal of "low" level and apply it to one of the input terminals of the test output circuit 32 in Fig.4. Because this output signal of "low" level of the third NOR gate 58 of the comparator CPi, that is, an resultant output signal generated from any one of the address test paths PQ₀-PQₙ₋₁, makes the output of the test output circuit 32 be on "low" level, it represents that all the refresh address signals Q₀-Qₙ₋₁ in need of performing one refresh cycle in the self-refresh operation mode have not been completely generated as a whole.

After lapsing aforementioned condition of that each of the refresh address signals Q₀-Qₙ₋₁ being generated is toggling from its "high" level to "low" level, or its "low" level to "high" level, all the NAND gates (similar to the NAND gate 48) and the first NOR gates (similar to the first NOR gate 52) of the comparators CP₀-CPₙ₋₁ can commonly receive the refresh address signals Q₀-Qₙ₋₁ of "high" levels from the second sub-paths DAi' only at the time of that all the refresh address signals Q₀-Qₙ₋₁ for the next self-refresh cycle are applied to their own second sub-paths DA₀'-DAₙ₋₁^{,} of the address test paths PQ₀-PQₙ₋₁, as shown in Fig.6. And then, referring to Fig.5, the third NOR gate 58 generate an output signal of "high" level, resulting in that the address test signal is generated as "high" level due to all inputs of the NAND gate 34 of the test output circuit 32 becoming "high" level. Which represents that all the refresh address signals Q₀-Qₙ₋₁ in need of performing one self-refresh cycle, that is, the prior self-refresh cycle, in the self-refresh operation mode are completely generated as a whole. Thus, the generating condition of the internal refresh address signals is detected through the data output buffer 28 and thereby the self-refresh cycle time can be verified.

In the embodiment described above, although the comparing control clock Φ2 is activated at the time of that the second pulse of the refresh clock ΦRFSH goes to its "high" level, it is possible that the activation time of the clock Φ2 can be designed to be enabled just on or before all the refresh address signals has been on their "low" levels in common, as an example on or before the n-1'th pulse of the refresh clock ΦRFSH goes to its "high" level, as shown in Fig.6. This can provide power consumption reducing effect to the semiconductor memory device according to the present invention.

Moreover, the number of signals to be applied to the comparator, for comparing the initial logic level of the refresh address signal and the present logic level of the refresh address signal, may be obvious to be variable by those skilled in this art.

As stated above, since the present invention provides a refresh test circuit with means for detecting whether the internal refresh address signals being used for a self-refresh cycle in the self-refresh operation mode has been completely generated or not yet, an accurate self-refresh cycle time can be obtained thereby and the disagreement between the substantial self-refresh cycle time and the standard self-refresh cycle time can be eliminated.

## Claims

1. A semiconductor memory device having a self-refresh function, comprising:
a memory cell array (10) with a plurality of memory cells;
a selection means (12,16) for selecting one of said memory cells;
an input (26) and output (28) means for storing and retrieving data into and from said memory cells;
a refresh control circuit (22) for generating a refresh clock (ΦRFSH);
a refresh address counter (24) for generating a plurality of refresh address signals (Q₀...Qₙ₋₁) in response to said refresh clock (ΦRFSH) and for applying said refresh address signals (Q₀...Qₙ₋₁) to said selection means (12,16);
**characterized by**
a refresh address test circuit (30) for detecting whether all refresh address signals (Q₀...Qₙ₋₁) necessary for an entire refresh cycle have been generated or not.

2. A semiconductor memory device as claimed in claim 1, wherein said refresh address test circuit (30) comprises a plurality of comparators (CPi) receiving initial logic levels of said refresh address signals (Q₀...Qₙ₋₁) and present logic levels of said refresh address signals, and a test output circuit (32) for receiving output signals of said comparators (CPi).

3. A semiconductor memory device as claimed in claim 2, wherein said refresh address test circuit (30) comprises latch means (LCi) for holding the initial logic levels of said refresh address signals (Q₀...Qₙ₋₁) and switch means (TGi) for transferring said initial logic levels of said refresh address signals to said comparators (CPi).

4. A semiconductor memory device as claimed in claim 2 or 3, wherein each of said comparators (CPi) is activated at least before said refresh address signals (Q₀...Qₙ₋₁) are commonly on the same logic level.

## Patentansprüche

1. Eine Halbleiterspeichereinrichtung mit einer Selbstauffrchungsfunktion, die umfaßt:
ein Speicherzellenfeld (10) mit einer Mehrzahl von Speicherzellen;
eine Auswähleinrichtung (12, 16) zur Auswahl von einer der genannten Speicherzellen;
eine Eingangs- (26) und Ausgangseinrichtung (28) zur Speicherung und Wiedergewinnung von Daten in die und aus den genannten Speicherzellen;
eine Auffrischungssteuerschaltung (22) zur Erzeugung eines Auffrischungstakts (ΦRFSH);
einen Auffrischungsadressenzähler (24) zur Erzeugung einer Mehrzahl von Auffrischungsadressensignalen (Qₒ...Qₙ₋₁) in Reaktion auf dem genannten Auffrischungstakt (φRFSH) und zum Anwenden der genannten Auffrischungsadressensignale Qₒ ... Qₙ₋₁) auf die genannte Auswahleinrichtung (12, 16);
**gekennzeichnet durch**
eine Auffrischungsadressenprüfschaltung (30) zur Bestimmung, ob alle Auffrischungsadressensignale (Qₒ...Qₙ₋₁), die für einen gesamten Auffrischungszyklus notwendig sind, erzeugt worden sind oder nicht.

2. Eine Halbleiterspeichereinrichtung, wie in Anspruch 1 beansprucht, wobei die genannte Auffrischungsadressenprüfschaltung (30) eine Mehrzahl Vergleicher (CPi), die anfängliche, logische Pegel der genannten Auffrischungsadressensignale (Qₒ...Qₙ₋₁) und gegenwärtige, logische Pegel der genannten Auffrischungsadressensignale erhält, und eine Prüfausgangsschaltung (32) umfaßt, um die Ausgangssignale der genannten Vergleicher (CPi) zu erhalten.

3. Eine Halbleiterspeichereinrichtung, wie in Anspruch 2 beansprucht, wobei die genannte Auffrischungsadressenprüfschaltung (30) eine Zwischenspeichereinrichtung (LCi) umfaßt, um die anfänglichen, logischen Pegel der genannten Auffrischungsadressensignale (Qₒ...Qₙ₋₁) zu halten, und eine Schalteinrichtung (TGi), um die genannten anfänglichen, logischen Pegel der genannten Auffrischungsadressensignale zu den genannten Vergleichem (CPi) zu übertragen.

4. Eine Halbleiterspeichereinrichtung, wie in Anspruch 2 oder 3 beansprucht, wobei jeder der genannten Vergleicher (CPi) aktiviert wird, zumindest bevor die genannten Auffrischungsadressensignale (Qₒ...Qₙ₋₁) gemeinsam auf dem gleichen logischen Pegel sind.

## Revendications

1. Dispositif de mémoire à semi-conducteurs comportant une fonction de rafraîchissement propre, comprenant :
un agencement de cellules de mémoire (10) avec une pluralité de cellules de mémoire ;
des moyens de sélection (12, 16) destinés à sélectionner une desdites cellules de mémoire ;
des moyens d'entrée (26) et des moyens de sortie (28) destinés à mémoriser et à récupérer des données dans et à partir desdites cellules de mémoire ;
un circuit de commande de rafraîchissement (22) pour générer une horloge de rafraîchissement (ΦRFSH) ;
un compteur d'adresses de rafraîchissement (24) pour générer une pluralité de signaux d'adresses de rafraîchissement (Q₀ ...Qₙ₋₁) en réponse à ladite horloge de rafraîchissement (ΦRFSH) et pour appliquer lesdits signaux d'adresses de rafraîchissement (Q₀, ··· Qₙ₋₁) auxdits moyens de sélection (12, 16) ;
caractérisé par :
un circuit de test d'adresses de rafraîchissement (30) pour détecter si tous les signaux d'adresses de rafraîchissement (Q₀,··· Qₙ₋₁) nécessaires pour un cycle entier de rafraîchissement ont été générés ou non.

2. Dispositif de mémoire à semi-conducteurs selon la revendication 1, dans lequel ledit circuit de test d'adresses de rafraichissemeni (30) comprend une pluralité de comparateurs (CPi) recevant les niveaux logiques initiaux desdits signaux d'adresses de rafraîchissement (Q₀, ··· Qₙ₋₁) en les présents niveaux logiques desdits signaux d'adresses de rafraîchissement et un circuit de sortie de test (32) pour recevoir les signaux de sortie desdits comparateurs (CPi).

3. Dispositif de mémoire à semi-conducteurs selon la revendication 2, dans lequel ledit circuit de test d'adresses de rafraîchissement (30) comprend des moyens de verrouillage (LCi) destinés à maintenir les niveaux logiques initiaux desdits signaux d'adresses de rafraîchissement (Q₀, ··· Qₙ₋₁) et des moyens de commutation (TGi) destinés à transférer lesdits niveaux logiques initiaux desdits signaux d'adresses de rafraîchissement vers lesdits comparateurs (CPi).

4. Dispositif de mémoire à semi-conducteurs selon la revendication 2 ou 3, dans lequel chacun desdits comparateurs (CPi) est activé au moins avant que lesdits signaux d'adresses de rafraîchissement (Q₀, ... Qₙ₋₁) soient communément au même niveau logique.
